(19) Europäisches Patentamt
European Patent Office
Office européen des brevets

(11) **EP 2 221 626 B1**

(12) **EUROPEAN PATENT SPECIFICATION**

(45) Date of publication and mention
of the grant of the patent:
**20.07.2011 Bulletin 2011/29**

(51) Int Cl.:
*G01R 31/11* (2006.01)  *H02J 3/00* (2006.01)

(21) Application number: **09153167.3**

(22) Date of filing: **19.02.2009**

(54) **A method for testing a power distribution system an a power distribution system analyser device**

Verfahren zum Testen eines Energieverteilungssystems und Energieverteilungssystemanalysegerät

Procédé pour tester un système de distribution d'énergie et dispositif analyseur du système de distribution d'énergie

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**25.08.2010 Bulletin 2010/34**

(73) Proprietor: **ABB Research Ltd.
8050 Zürich (CH)**

(72) Inventors:
• **Haffner, Ken Yves
CH-5400, Baden (CH)**
• **Steiger, Olivier
CH-8032, Zürich (CH)**
• **Krippner, Peter
D-76199, Karlsruhe (DE)**
• **Deck, Bernhard
D-79809, Weilheim (CH)**

(74) Representative: **ABB Patent Attorneys
C/o ABB Schweiz AG
Intellectual Property (CH-LC/IP)
Brown Boveri Strasse 6
5400 Baden (CH)**

(56) References cited:
**EP-A- 1 744 429       GB-A- 947 060
US-A- 3 559 176       US-A- 5 495 384
US-A1- 2005 189 817**

• **KASHEM M A ET AL: "Network reconfiguration
for load balancing in distribution networks" IEE
PROCEEDINGS: GENERATION, TRANSMISSION
AND DISTRIBUTION, INSTITUTION OF
ELECTRICAL ENGINEERS, GB, vol. 146, no. 6, 12
November 1999 (1999-11-12), pages 563-567,
XP006013512 ISSN: 1350-2360**

EP 2 221 626 B1

**Description**

**BACKGROUND**

The present disclosure generally relates to a method for testing at least one power cable arranged within a power supply network, and in particular relates to controlling the power supply network on the basis of an operating condition of the power supply network. Furthermore, the present disclosure relates to a power cable analyser device adapted for testing a power cable arranged within a power supply network.

An operating condition of an electrical wiring may be a critical issue in many applications such as power supply networks, aircraft wiring, cables in automobiles, wirings in security-relevant applications such as power plants and so on. Thus, a proper functioning of an electrical wiring and a detection of possible faults is a subject of extensive investigation. A detection of wiring faults and/or operating conditions of wirings with a high resolution is a requirement for many electrical devices employing complex wiring structures.

A detection and localisation of faults in an electric power cable is an important task in measurement science and technology. Power cables such as medium voltage power cables for a transport of electrical energy in the medium voltage power supply region may exhibit a large variety of failures such as an open circuit, a short circuit, water intrusion into the interior of the power cable, etc.

GB 974 060 (Siemens & Halske) discloses a pulse reflexion method for localising an irregularity in electrical cables.

In order to provide a safe and reliable operation of a power supply network having a plurality of power cables, it is necessary to operate the power supply network in such a way that a maximum load rating of a specific power cable is not exceeded even if above-mentioned failures occur.

EP 1 744 429 (Honey well) discloses the tripping of a switch based on conductor data and measured current.

It is thus required to improve a reliability of a power supply network having a plurality of power cables which are subject to environmental stress and varying electrical conditions.

**SUMMARY**

In view of the above, a method for testing a power distribution system according to claim 1, and an analyser device according to claim 11 are provided.

Accrding to one aspect of the invention, the method for testing a power distribution system of a power supply network comprises: coupling of a first electrical signal into the power distribution system to be tested; propagating the first electrical signal within the power distribution system to be tested; receiving a second electrical signal which is a portion of the first electrical signal reflected within the power distribution system; measuring a signal variation parameter between the first electrical signal and the second electrical signal; obtaining, from the measured signal variation parameter, at least one location of a critical conducting section within the power distribution system; obtaining, from the measured signal variation parameter, a maximum load rating of the critical conducting section; and outputting a control signal for controlling the power supply network such that the power transferred on the critical conducting section does not exceed the maximum load rating.

According to another aspect to the invention, the analyser device, which is adapted for testing a power distribution system of a power supply network, comprises: a transmitter unit adapted for transmitting a first electrical signal; a coupling unit adapted for coupling the first electrical signal into the power distribution system to be tested, for propagating the first electrical signal within the power distribution system to be tested; a receiver unit adapted for receiving a second electrical signal which results from a portion of the first electrical signal being reflected within the power distribution system; an evaluation unit adapted for measuring a signal variation parameter between the first electrical signal and the second electrical signal and for obtaining, from the measured signal variation parameter, a location of a critical conducting section within the power distribution system and a maximum load rating of the critical conducting section; and an output unit adapted for outputting a control signal for controlling the power supply network such that the power transferred on the critical conducting section does not exceed a maximum load rating.

Generally, the obtaining of the maximum load rating may include evaluating a cross correlation function between the first electrical signal and the second electrical signal.

Aspects of the invention also include apparatuses for carrying out the disclosed methods and apparatus parts for performing each described method step. These method steps may be performed by way of hardware components, a computer programmed by appropriate software, by any combination of the two or in any other manner. Furthermore, methods by which the described apparatuses operate are also included. This includes method steps for carrying out every function of the apparatus or manufacturing every part of the apparatus. Hence, it is clear that e.g. the additional method steps of dependent claims 2-11 may be implemented by corresponding apparatus parts, and that the additional apparatus features of dependent claims 13-16 may result is corresponding method steps.

Further exemplary embodiments are according to the dependent claims, the description and the accompanying drawings.

## DRAWINGS

A full and enabling disclosure, including the best mode thereof, to one of ordinary skill in the art is set forth more particularly in the remainder of the specification including reference to the accompanying drawings wherein:

Fig. 1 shows a power supply network including four substations connected via power cables having attached power cable analyser devices, according to a typical embodiment;

Fig. 2 depicts a coupling of a power cable analyser device to a power cable to be tested;

Fig. 3 illustrates probe and reflection signals propagating along a power cable to be tested;

Fig. 4 exhibits a time difference between a probe signal and a reflected signal as a signal variation parameter;

Fig. 5 shows a power cable analyser device connected to a power cable to be tested arranged within a power supply network, wherein the power supply network is controlled by a control signal derived from the power cable analyser device;

Fig. 6 shows a block diagram of a power cable analyser device according to a typical embodiment;

Fig. 7 shows different signal shapes of a reflected electrical signal (Fig. 7(b) and 7(c)) with respect to a first electrical signal as a probe signal (Fig. 7(a)), according to another typical embodiment; and

Fig. 8 is a flowchart illustrating a method for testing a power cable arranged within a power supply network according to a typical embodiment.

## DETAILED DESCRIPTION

Reference will now be made in detail to the various exemplary embodiments, one or more examples of which are illustrated in the drawings. Each example is provided by way of explanation and is not meant as a limitation. For example, features illustrated or described as part of one embodiment can be used on or in conjunction with other embodiments to yield yet a further embodiment. It is intended that the present disclosure includes such modifications and variations.

A number of embodiments will be explained below. In this case, identical structural features are identified by identical reference symbols in the drawings. The structures shown in the drawings are not depicted true to scale but rather serve only for the better understanding of the embodiments.

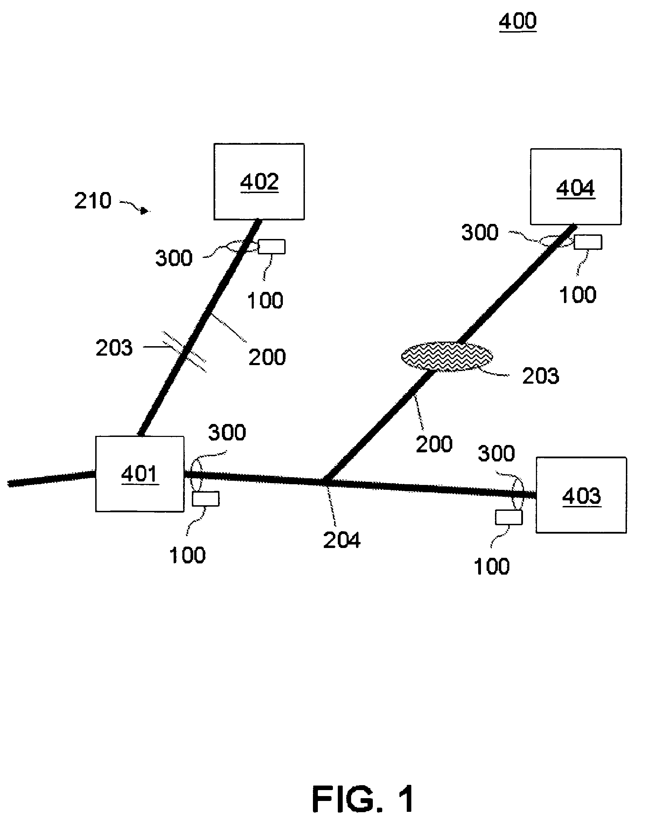

Fig. 1 is a block diagram of a power supply network 400 including four substations 401, 402, 403 and 404, according to a typical embodiment. The substations are connected to each other via power cables 200. At the exit or entrance of the substation 401-404, respectively, power cable analyser devices 100 are coupled to the power cable 200 to be tested via a coupling unit 300. The substations 401-404 in the power supply network 400 are adapted to control a maximum load applied at the power cables 200.

Generally, the following description and the Figures relate to the case that a power cable 200 or a portion of a power cable 200 is to be tested. While this case is an important general aspect, the invention is not limited to this case, but also allows testing other components of a power distribution system 210, i.e. the part of the supply network 400 in which the testing is to be done. Such other components may be a power switch or interrupter. The cable or the further component(s) may be tested e.g. by coupling an electrical signal to a cable or to other parts of the power distribution system, and then propagating the electrical signal to the part which is to be tested. Thereby, e.g. an operating condition of a power cable interrupter of the power distribution system may be tested.

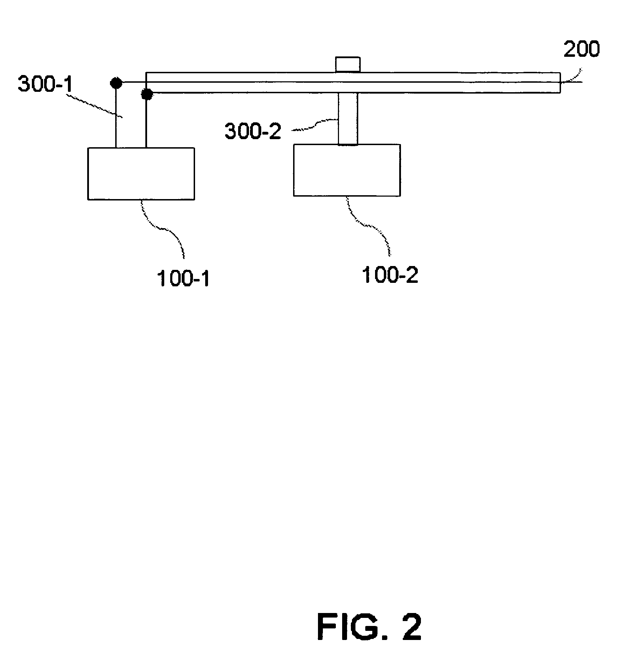

Measurement units adapted for determining an appropriate operation of a power cable 200 to be tested are contained in the cable analyser devices 100. The cable analyser device 100 can be provided within the bushings of the power cable 200 to be tested. A coupling of probe signals emitted from the power cable analyser device 100 towards the power cable 200 to be tested may be performed by means of a coupling unit 300 which will be described herein below with respect to Fig. 2.

A critical conducting sections 203 is exemplary shown in Fig. 1, the critical conducting section 203 representing e.g. a cable failure of the power cable 200 or a water intrusion into the power cable 200.

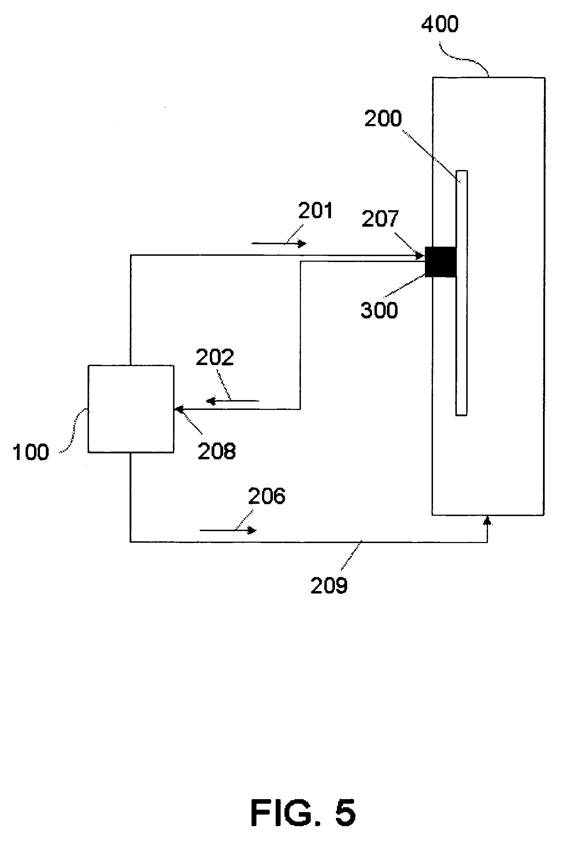

It has been found by the inventors that this kind of critical conducting section does not necessarily mean that the cable cannot be used at all. Instead, it is in many cases sufficient to ensure that the load of the cable is not excessive. To this purpose, a control signal for controlling at least a part of the power supply network 400 is provided by at least one cable analyser device 100 such that the power transferred on the critical conducting section 203 does not exceed a maximum load rating (the maximum load rating is obtained by analysing the cable as explained in more detail below). Such kind of load rating may be at least one of a power load rating defining a maximum electrical power to be transferred, a voltage load rating which defines a maximum voltage applicable at the power cable, or a current rating defining a maximum admissible current throughput. In order to adjust the maximum load rating of the critical conducting section 203, a control signal for controlling the power supply network 400 such that the power transferred on the critical conducting section 203 does not exceed the maximum load rating is issued, as will be described herein below with respect to Fig. 5.

A location of the critical conducting section 203 along at least one power cable 200 within the power supply network 400 may be obtained from a comparison of a signal reflected at the critical conducting section 203, with a probe signal which has been sent by at least one cable analyser device 100. Due to the reflection at the critical conducting section 203, the probe signal is subject to a signal variation, the signal variation parameter of which depends on the nature and location of the critical conducting section 203, as will be described herein below.

Using the method for testing the power cable 200 arranged within the power supply network 400, it is thus possible to determine a location of the critical conducting section 203. By means of appropriate measures it is then possible to distribute an electrical load within the power supply network 400 such that an overload of a damaged or partially damaged cable 200 is avoided.

Fig. 2 illustrates a schematic set-up adapted for connecting a power cable analyser device 100 to a power cable 200 to be tested. A similar setup could also be used for coupling a corresponding analyser to another part of the power distribution system 210 (see Fig. 1) to be tested. The power cable 200 may be a coaxial cable, a twisted pair cable, a flat ribbon cable, etc. which is suited for the application within the power supply network 400 described above with respect to Fig. 1.

Different connection schemes are depicted in Fig. 2. A first power cable analyser device 100-1 is galvanically connected to the inner and outer conductors of the coaxial power cable 200 to be tested. The corresponding connection device 300-1 simply consists of two wires connected to the inner and outer conductor of the coaxial cable 200, respectively.

As another example, a power cable analyser device 100-2 (a second power cable analyser device) is capacitively coupled to the coaxial power cable 200 via a capacitive coupling unit 300-2. The capacitive coupling unit 300-2 is designed such that a direct connection to the inner conductor and/or to the outer conductor of the power cable 200 to be tested is not required. Such capacitive coupling is efficient at those portions of the cable which are not or only weakly screened. Hence, as a general aspect, it is preferred that the capacitive coupling is provided, for a screened power cable 200, at a portion of the cable at which the screening is reduced or absent, such as a cable bushing of the power cable 200. Then, it is possible to access the power cable 200 to be tested without interrupting the cable and/or without connecting inner and outer wires to connection wires of a cable analyser device 100. According to the set-up shown in Fig. 2, an injection of probe signals as first electrical signals may be obtained using a galvanic or a capacitive coupling 300-1 and 300-2, respectively.

Alternatively, the power cable analyser device 100-2 may be inductively coupled to the power cable 200. Since in this case the coupling is weak for high frequencies, it is more difficult obtaining a high spatial resolution. However, the inductive coupling allows coupling also at screened portions of the cable, so that the power cable 200 may be accessed at any place along its length.

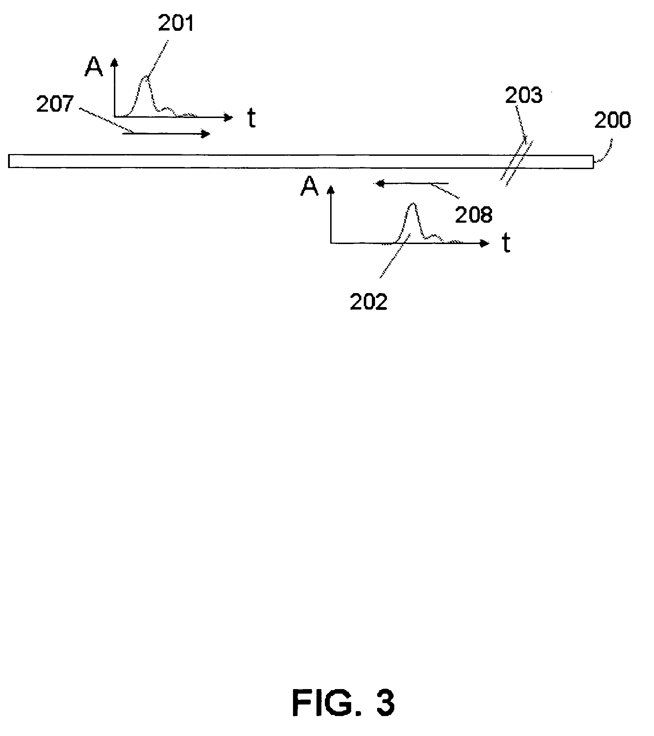

Fig. 3 is a schematic diagram illustrating a power cable 200 to be tested having a critical conducting section 203. The critical conducting section 203 in the power cable 200 may be caused by a modified operating condition of the power cable 200. The modified operating condition of the power cable 200 may include at least one of an electrical property of the power cable and a property of a cable environment. An electrical property of the power cable 200 may include at least one of a ground contact, a blown fuse, an open circuit, a short circuit, a partially open circuit, a partially short circuit, an insulation state, a partial discharge, an arc fault, an operating condition of a cable interrupter, etc.

The property of a cable environment of the power cable 200 to be tested may include at least one of an ambient humidity, a water intrusion into the interior of the power cable, temperature variations, etc. In accordance with a typical embodiment, an electrical probe signal, i.e. a first electrical signal 201, is coupled into the power cable 200 to be tested via a coupling unit 300 described herein above with respect to Figs. 1 and 2. This first electrical signal 201 propagates as a probe signal along the power cable 200 to be tested towards the electrical conducting section 203. The first electrical signal 201 propagates as an incident signal along the power cable 200 to be tested without any significant interruption or reflection as long as the impedance along the power cable 200 to be tested remains at a constant value. The electrical signal energy of the first electrical signal 201 is transmitted down the power cable 200 to be tested. When the first electrical signal 201 reaches the end of the power cable 200 or any impedance variation along the power cable 200 to be tested, at least a part of the electrical signal energy transported by the first electrical signal 201 is reflected back in the opposite direction. The energy and shape of a second electrical signal 202 which is a signal reflected at the critical conducting section 203 is determined by a reflection coefficient R which may be written as follows:

$$R = (Z_C - Z_0) / (Z_C + Z_0) \tag{1}$$

wherein $Z_0$ is an impedance of the power cable 200 and $Z_C$ is an impedance at the critical conducting section 203. The above formula assumes an abrupt change in impedance, but may be generalized to a smooth impedance variation along the cable. Such a smooth impedance variation can be considered as a series of (infinitesimally) small reflections within the cable region at which the impedance variation occurs.

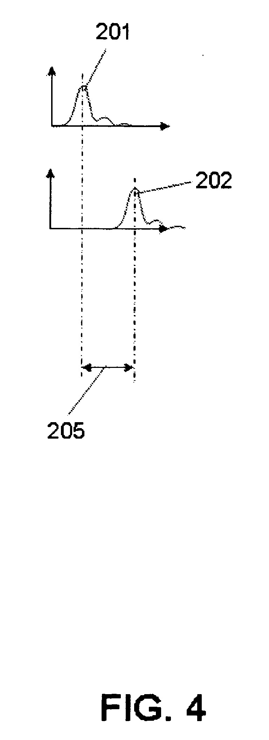

As the propagation directions of the two signals 201, 202, i.e. a forward propagation direction 207 and a backward propagation direction 208, are opposite to each other, a RADAR principle may be applied in order to obtain a location of the critical conducting section 203 along the power cable 200 to be tested. Thus, e.g. working in a time domain reflection mode, a location of the critical conducting section 203 along the power cable 200 to be tested may be determined by means of a time difference measurement (see also Fig. 4 below).

It is noted here, however, that the time difference measurement in the time domain reflection (TDR) mode is only one of a variety of methods to compare the probe signal, i.e. the first electrical signal 201, with the reflected signal, i.e. the second electrical signal 202. In order to establish a method for testing the power cable 200 arranged within the power supply network 400, a second electrical signal 202 may be received, the second electrical signal 202 resulting from a portion of the first electrical signal 201 being reflected within the power cable 200 at the critical conducting section 203. Then, a signal variation parameter may be measured between the first electrical signal 201 and the second electrical signal 202. From the signal variation parameter, a location of the critical conducting section 203 within the power supply network 400 may be obtained.

The signal variation parameter may include, besides the information which is needed for obtaining the location (e.g. a time delay between the first signal and the second signal), additional information (e.g. information relating to the change of shape, of frequency distribution, and/or of phase(s) between the first and the second signal or portions thereof). Hence, when reference is made to the signal variation parameter, this does not imply that the full information within this parameter is used, but also includes the case that only a partial information contained in the signal variation parameter is used.

Although Fig. 3 shows the situation where a time delay between the first electrical signal 201 and the second electrical signal 202 is measured in order to determine a location of the critical conducting section 203 within the power cable 200 to be tested, other methods for obtaining the location information may be applied as will briefly be outlined herein below.

As shown in Fig. 3, the first electrical signal 201 is provided as a pulsed probe signal having an amplitude A which varies in dependence of time t. If a reflection at the critical conducting section 203 occurs as described above, the overall shape of the second electrical signal 202 may be similar to the shape of the first electrical signal 201, i.e. an amplitude variation A with respect to a time t is similar in the backward propagation direction. There is, however, a time delay between the first electrical signal 201 and the second electrical signal 202 which can be used for determining the location of the critical conducting section 203, as will be elucidated herein below with respect to equations (2) and (3).

It is noted here that the reflection which is required in order to obtain the second electrical signal 202 generally results from a variation of the impedance along the power cable 200 to be tested, which in turn can result e.g. from a mismatch in impedances, a change of electrical properties of the power cable and/or a change of properties of a cable environment. Hence, these phenomena can be diagnosed by the described technique. Other examples of such phenomena are given below.

Measurements in the time domain reflection mode yield a time delay indicated by the time shift of the second electrical signal 202 with respect to the first electrical signal 201, as shown in Fig. 4. Furthermore, the reflection measurements may be performed in the frequency domain, i.e. a frequency domain reflectometry (FDR) may be applied. Compared to the time domain reflectometry, the frequency domain reflectometry may provide additional information about the critical conducting section 203 within the power cable 200 to be tested. By testing the power cable 200 using several frequencies, an extremely accurate information on the fault location may be obtained.

The method based on frequency domain reflectometry employs a generation of a signal having various controlled frequencies, and of measuring quantities relating to the frequencies and / or the phases (relative to the emitted signal) present in of the reflected signal. For example, in frequency-modulated continuous wave (FMCW) reflectometry, the generated signal which is coupled into the cable 200 has a rapid frequency sweep that covers a predetermined frequency range.

Frequency domain reflectometry is based on the generation of resonances between the reflected and transmitted signals. Over a broad frequency range there are many resonances which give rise to many periodic ripples. The frequency spacing between this kind of ripples includes information of a location of the critical conducting section 203.

The measurement signals acquired in a frequency domain reflectometer may be subjected to a fast Fourier transformation (FFT). The FFT output pulses can be displayed and analysed for obtaining the location of the critical conducting section 203.

The time domain reflectometry (TDR) can be combined with a spread spectrum technique (SST) which is a method where an electromagnetic energy in a particular bandwidth is deliberately spread in the frequency domain. This results in a signal with a wider bandwidth. Such kind of spread spectrum time domain reflectometry (SSTDR) techniques may also be used for a detection of the critical conducting section 203 within the power cable 200 to be tested. The SSTDR method is capable of monitoring a large variety of failures within a power cable 200 to be tested. Generally, a combination of time domain and frequency domain spectroscopy allows combining the advantages of both approaches. To this purpose, a mixed-signal reflectometer (time domain and frequency domain) is used for the combined reflectometry.

These failures may include, but are not restricted to, a ground contact, a blown fuse, an open circuit, a short circuit, a partially open circuit, a partially short circuit, an insulation state of the power cable 200 to be tested, a partial discharge or an arc fault within the power cable 200, an operating condition of a power cable interrupter of the power cable 200, etc. In these techniques, the term "portion" of a signal does not necessarily refer to a real-time portion of the signal but may also refer to e.g. a frequency-domain portion or any other portion of the signal.

The first electrical signal may be provided as at least one of a spread spectrum signal, a modulated signal, and a pulse signal. The signal variation parameter may include a time delay between the first electrical signal and the second electrical signal. Moreover, the signal variation may include a variation in a predetermined frequency band, wherein the second electrical signal is spectrally resolved.

Fig. 4 is a schematic diagram showing the acquisition of a signal difference 205 as a signal variation parameter. In the diagram shown in Fig. 4 the signal variation parameter is represented as a time delay 205 between the first electrical signal 201 and the second electrical signal 202 thus indicating a variation between the first electrical signal 201 (incidence signal) and the second electrical signal 202 (reflected signal). In the case of time domain reflectometry, this signal variation parameter is just a time difference which can be obtained by a correlation procedure. As the shapes of the first and second electrical signals 201 and 202, respectively, are similar to each other, a cross correlation function may yield a time shift of the second electrical signal 202 with respect to the first electrical signal 201. From the time shift, a location of the critical conducting section 203 along the power cable 200 to be tested (see Fig. 3 above) can be evaluated using a known signal propagation velocity within the power cable 200 to be tested.

Fig. 5 is a block diagram of a power cable analyser device 100 arranged at a power supply network 400 in order to test power cables 200 to be tested within the power supply network 400. Although only one power cable 200 to be tested is shown, the power supply network 400 may include a plurality of power cables 200 adapted to distribute electrical power among substations 401-404 (see Fig. 1). In the typical embodiment shown in Fig. 5, a testing of one power cable 200 to be tested is shown. The power cable analyser device 100 is connected to the power cable 200 to be tested via a coupling unit 300 which may be provided as one of a capacitive coupling unit or a galvanic coupling unit.

The coupling unit 300 thus provides a galvanic or a capacitive coupling of signals to the power cable 200 to be tested. The power cable analyser device 100 essentially is connected to the coupling unit 300 via two signal paths, i.e. via a forward path in a forward propagation direction 207 and via a backward path in a backward propagation direction 208. A first electrical signal 201 represents the probe signal, and this signal is propagated in the forward propagation direction 207 towards the coupling unit 300 where it is coupled into the power cable 200 to be tested. If any reflection due to impedance mismatch, etc. occurs within the power cable 200 to be tested (as has been described herein above with respect to Fig. 3), then a reflected signal may be obtained which is provided as a second electrical signal 202 on the backward propagation path in the backward propagation direction 208, towards the power cable analyser device 100.

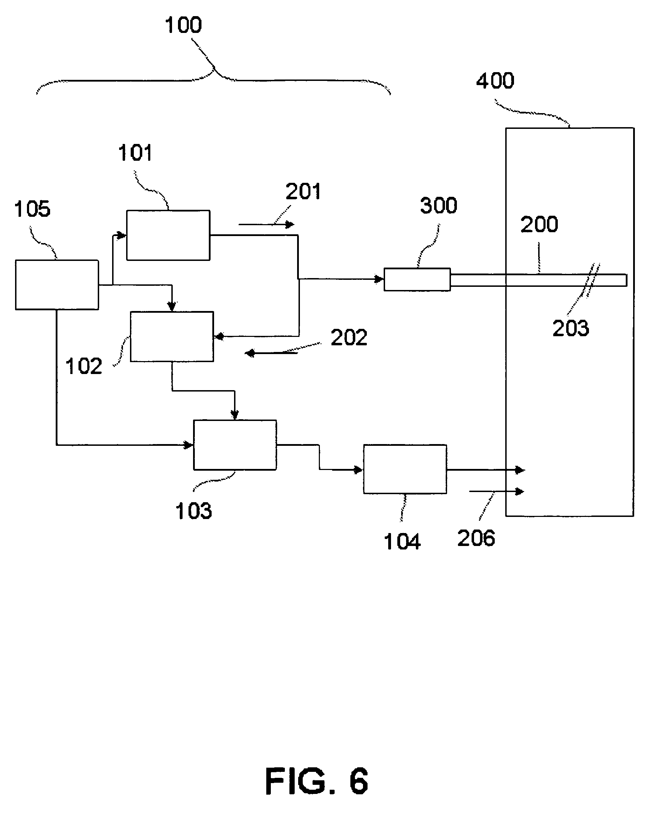

The power cable analyser device 100 receives the second electrical signal 202 which is a portion of the first electrical signal 201 reflected within the power cable 200 to be tested. In an evaluation unit which will be described herein below with respect to Fig. 6, a relation between the first electrical signal 201 and the second electrical signal 202 is established. The power cable analyser device 100 is then capable of measuring a signal variation parameter between the first electrical signal 201 and the second electrical signal 202. From the measured signal variation parameter, a location of a critical conducting section 203 (described herein above with respect to Fig. 3) within the power supply network 400 (see Fig. 1) may be obtained.

Then, a maximum load rating of the critical conducting section 203 may be obtained and a control signal 206 for controlling the power supply network 400 such that the power transferred on the critical conducting section 203 does not exceed the maximum load rating is outputted. The control signal 206 is transferred to the power supply network 400 via a control line 209. Within the power supply network 400, appropriate measures can be taken in order to avoid that power transferred on the critical conducting section 200 exceeds the maximum load rating of the respective power cable 200.

The measurement of the signal variation parameter, the derivation of a location of the critical conducting section 203 within the power supply network 400 and the determination of a maximum load rating of the critical conducting section 203 will be described herein below with respect to Fig. 6.

Fig. 6 is a block diagram illustrating functional blocks of the power cable analyser device 100 according to a typical embodiment. The power cable analyser device 100 is connected to a power supply network 400. The power cable analyser device 100 includes a transmitter unit 101 which provides the first electrical signal 201.

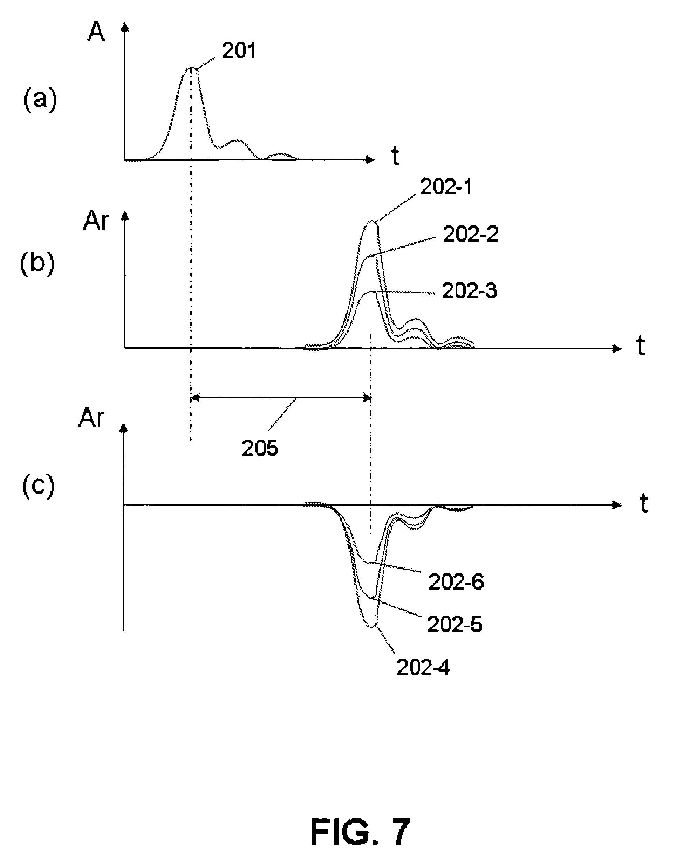

It is noted here that, albeit different signals with respect to TDR and SSTDR, FDR have been described herein above with respect to Figs. 2 and 3, according to the present embodiment a pulse-shaped first electrical signal 201 is provided as the probe signal. The signal shapes and respective signal shape variations in the reflected signal will be described herein below with respect to Fig. 7. The first electrical signal 201 is propagated via the coupling unit 300 towards the power cable 200 to be tested. The coupling of the first electrical signal 201 into the power cable 200 has been described herein above with respect to Fig. 2 and is not repeated here in order to avoid a redundant description.

A critical conducting section 203 may be present in the power cable 200 to be tested such that a reflected signal is obtained as the second electrical signal 202 which is transferred via the coupling unit 300 to a receiver unit 102 of the power cable analyser device 100. Moreover, the power cable analyser device 100 includes a control unit 105 adapted for controlling the transmitter unit 101 and the receiver unit 102.

It is noted here, albeit not shown in Fig. 6, that the transmitter unit 101 and the transceiver unit 102 may be provided as an integral transceiver unit. An output signal of the receiver unit 102 is transferred to an evaluation unit 103 which is also controlled by the control unit 105. The evaluation unit 103 is adapted for establishing a relation between the first electrical signal 201 and the second electrical signal 202 and for measuring a signal variation parameter between the first electrical signal 201 and the second electrical signal 202.

The signal variation parameter may include, but is not restricted to, a time delay between a portion of the first electrical signal 201 and the corresponding portion of the second electrical signal 202. Furthermore, the signal variation parameter may include variations in shape and/or amplitude distribution of the reflected, second electrical signal 202 as will be described herein below with respect to Figs. 7(b) and 7(c). The evaluation unit 103 may include a memory unit where signal shapes of calibration measurements are stored. Signal shapes of such kind of calibration measurements may be stored previous to testing the power cable 200 to be tested such that an actually measured signal shape can be compared to signal shapes stored in the memory unit of the evaluation unit 103. Thus it is possible to evaluate, from a comparison of the actually measured signal shape of the second electrical signal 202 with respect to the first electrical signal 201, with the calibration curves of the signal shapes, an actual load rating.

In particular, a measured signal variation parameter may be compared to a reference signal variation parameter stored in a memory unit in advance. Then the maximum load rating may be determined from this comparison and a reference load rating which was obtained for the reference signal variation parameter at a previous measurement. The reference signal variation parameter may be stored in a memory unit provided in the evaluation unit. E.g., the reference signal variation parameter may be obtained by performing a reflection measurement at a reference power cable, the maximum load rating of which is known. This load rating of the reference cable then can be used as the reference load rating. Typically the evaluation unit includes a comparison unit adapted for comparing the reference signal variation parameter obtained previously to measuring the signal variation parameter, and the actually measured signal variation parameter, the reference signal variation parameter preferably being stored in advance in the memory unit.

Furthermore, at least two signal variation parameters may be measured for at least two power cables, wherein the measured signal variation parameters are compared to each other, and wherein the maximum load rating is determined from the comparison of the at least two signal variation parameters. Typically at least two load ratings obtained when the signal variation parameters for the at least two power cables (200) are measured, are compared to each other, preferably by means of the comparison unit.

The signal variation parameter may represent an impedance variation signal between an impedance of the power cable and an impedance of the critical conducting section, more specifically a spatial impedance variation between an impedance of the critical conducting section 203 and an impedance of a conducting section adjacent to the critical conducting section 203. Preferably, the impedance variation is measured at a function of time, which allows a parameter indicating a temporal variation to be obtained. At least one feature of the impedance variation signal may be used for evaluating a maximum load rating, preferably at least one of a temporal derivative of the impedance variation signal, a maximum signal value, a minimum signal value, a signal variance, a time duration of an impedance variation, etc.. E.g., if the actually measured impedance variation signal measured for a specific power cable 200 exceeds the maximum signal value, then the maximum load rating allowable for this specific power cable 200 is reduced to a lower value. Thus an overloading of this power cable 200 can be avoided.

Also, it is possible predicting a possible future fault event in the critical conducting section. In particular, it can be predicted, whether there is a significant risk of a future fault at the critical conducting section 203. Here, a significant risk may be indicated e.g. by giving a probability estimate for the risk, and/or by indicating that the risk is higher than a given threshold risk. The prediction can based on the measured signal variation parameter, e.g. by comparing the measured signal variation parameter to stored signal variation parameters to which a corresponding fault risk estimate is assigned. Preferably, the risk prediction is based on the time-dependent behaviour of the measured signal variation parameter. Hence, for example a strong change or fluctuation in time may indicate an elevated risk.

The information (maximum load and, if applicable, risk of future fault etc.) based on the measured signal variation parameter is transferred to an output unit 104 which is adapted for outputting a location of a critical conducting section 203 within the power supply network and for outputting a control signal 206 for controlling the power supply network 400 such that the power transferred on the critical conducting section 203 does not exceed a maximum load rating.

The second electrical signals 202 which are reflected at the critical conducting section 203 of the power cable 200 to be tested are discussed herein below with respect to Figs. 7(b) and 7(c). The power cable analyser device 100 may thus be calibrated by preparing a plurality of different power cables 200 having different critical conducting sections 203. The second electrical signals 202 obtained by a reflection of the first electrical signal 201 at a prepared critical conducting section 203 may then be used as a reference for an actual measurement of an unknown power cable 200 to be tested. The difference measurements may be stored as calibration measurements within the evaluation unit 103 of the power cable analyser device 100.

The control signal 206 thus contains information on the signal variation parameter. The information contained in the signal variation parameter may include at least one of a time delay between a portion of the first electrical signal 201 and the corresponding portion of the second electrical signal 202 and/or information on a shape variation, with respect to the portion of the first electrical signal 201, of the corresponding portion of the second electrical signal 202.

Whereas the time delay is determined by the location of the critical conducting section 203 of the power cable 200 to be tested, the shape variation may contain information on the operating condition of the power cable 200. The operating condition of the power cable 200 may include at least one electrical property of the power cable. The at least one electrical property of the power cable may include at least one of a ground contact, a blown fuse, an open circuit, a short circuit, a partially open circuit, a partially short circuit, an insulation state, a partial discharge, an arc fault and an operating condition of a power cable interrupter.

Furthermore, the operating condition of the power cable 200 may include at least one property of a cable environment. The at least one property of a cable environment may include at least one of an ambient humidity, a water intrusion into the interior of the power cable 200, environmental conditions such as sand, wet grass, gravel and stones.

Moreover, the power cable analyser device 100 may include a correlator unit which is adapted for correlating the first electrical signal 201 and the second electrical signal 202. By obtaining a correlation function, a measure for a similarity of the first electrical signal 201 and the second electrical signal 202 may be obtained. From the obtained correlation coefficient, the shape variation with respect to the portion of the first electrical signal 201, of the corresponding portion of the second electrical signal 202, may be obtained. It is noted here that the signal variation may include a variation in a predetermined frequency band, wherein the second electrical signal 202 is then spectrally resolved.

As the cable analyser device 100 may be applied at the power supply network 400 during an operation of the power supply network 400, it is possible to obtain a fault information within the power cable 200 to be tested at a predetermined electrical load applied at the power cable 200. In order to provide measurement data at any time during an operation of the power supply network 400, the entire power cable analyser device 100 may be integrated into a bushing of the power cable 200 to be tested. Such kind of bushing of the power cable 200 to be tested may provide enough space in order to house the components of the power cable analyser device 100 which are shown and have been described with respect to Fig. 6 herein above. Furthermore, as the power cable analyser device 100 is adapted for testing power cables 200, a power supply for the power cable analyser 100 itself can be provided via the power cable 200 to be tested. Hence, at least some of the power for the testing of the power distribution system can be extracted from the power distribution system, more particularly from the power cable to be tested. This has the advantage that no separate power source is required.

Fig. 7 shows three graphs illustrating signal waveforms used for testing a power cable 200 to be tested according to a typical embodiment. Fig. 7(a) illustrates a typical waveform of the first electrical signal 201. Here, an amplitude A of the first electrical signal 201 is plotted as a function of time t. It is noted here, albeit not shown in the Figures, that arbitrary waveforms for the first electrical signal 201 may be provided. As an explanation of a method for testing a power cable 200 according to a typical embodiment, a pulse shape with respect to time t for the first electrical signal 201 has been chosen.

It is possible, however, to use different reflectometry techniques such as, but not restricted to, spread spectrum time division reflectometry (SSTDR) and frequency domain reflectometry (FDR), as has been described previously. The reflectometry processes shown in Figs. 7(a), 7(b) and 7(c) are based on time domain reflectometry (TDR), albeit the present disclosure is not restricted to time domain reflectometry.

Figs. 7(b) and 7(c) show signal shapes of second electrical signals 202 reflected at a critical conducting section 203 of the power cable 200 to be tested. Herein, an amplitude of the reflection signal is designated as Ar, and a time is indicated by t. In accordance with equation (1) above, the reflection coefficient and thus the reflected signal may vary in dependence of an impedance mismatch between an impedance of the power cable $Z_0$ and an impedance of the critical conducting section 203 ($Z_C$). Moreover, as can be seen from equation (1) above, the reflection coefficient can be positive or negative. Fig. 7(b) shows signal waveforms and shape variations, respectively, for positive reflection coefficients, i.e. the signal waveforms 202-1, 202-2 and 202-4 of the second electrical signal 202. In accordance with equation (1) above, the reflection coefficient is positive in this case, because the impedance of the critical conducting section 203 exceeds the impedance of the power cable ($Z_0$). The more the impedance $Z_C$ of the critical conducting section 203 exceeds the impedance $Z_0$ of the power cable 200, the larger the amplitude Ar in Fig. 7(b) is. Thus, the largest impedance mismatch results in a second electrical signal indicated by reference numeral 202-1, wherein reference numerals 202-2 and 202-3 indicate a medium impedance mismatch and a low impedance mismatch, respectively.

Fig. 7(c) shows the situation for a negative reflection coefficient in accordance with equation (1) above. A negative reflection coefficient and thus a negative amplitude Ar of the second electrical signal 202 results from an impedance mismatch, wherein the impedance of the critical conducting section 203 $Z_C$ is smaller than the impedance of the power cable 200 to be tested. For the signal waveforms shown in Fig. 7(c), the second electrical signal indicated by a reference numeral 202-4 corresponds to the largest impedance mismatch, wherein the signal waveforms indicated by reference numerals 202-5 and 202-6 correspond to a medium impedance mismatch and a low impedance mismatch, respectively.

From a comparison of the signal waveforms of the second electrical signal 202 shown in Figs. 7(b) and 7(c) with respect to the signal waveform of the first electrical signal 201 an amount and a nature of an impedance mismatch may be determined using the evaluation unit 103 shown in Fig. 6. As indicated by equation (1) above, the curves shown in Fig. 7(b) correspond to an open circuit or to an at least partially open circuit, wherein the curves shown in Fig. 7(c) correspond to a short or to an at least partially short circuit. This kind of impedance mismatches may be caused by different operating conditions of the power cable 200 to be tested. These operating conditions may be based on electrical properties of the power cable 200 and/or properties of a cable environment. These properties have been described herein above, but are not restricted to the properties mentioned in this disclosure.

Besides a shape analysis of the second electrical signal 202 with respect to the first electrical signal 201, a time delay 205 between the first electrical signal 201 and the second electrical signal 202 may be obtained. The time delay 205 is a direct measure for the location of a critical conducting section 203 within the power cable 200. The time difference or time delay 205 may be measured between an input location where the first electrical signal 201 is input into the cable and a location of a reflecting portion within the cable. The system may be calibrated using a known distance between the input portion and the reflecting portion, which is assumed to be D. Then using a time delay 205 (At), a propagation velocity c of the first electrical signal 201 and the second electrical signal 202 within the power cable 200 to be tested may be determined in accordance with the following equation (2):

$$c\ =\ 2D/\Delta t \tag{2}$$

Using this calibration, a location of a critical conducting section 203 within the power cable 200 to be tested may be obtained using the following equation (3):

$$L\ =\ c\cdot\Delta t/2 \tag{3}$$

$\Delta t$ in equation (3) above is the measured time delay between transmitting the first electrical signal 201 into the power cable 200 to be tested and receiving a second electrical signal 202 at the same location. A length L in equation (3) above thus indicates a geographical distance between the signal input/output location and the location of the critical conducting section 203.

In order to provide a control signal 206 which has been described with respect to Fig. 6, a calibration of the power cable analyser device 200 may be performed wherein the calibration may be provided as follows. In order to determine a location of a critical conducting section 203 within the power cable 200 to be tested, equations (2) and (3) mentioned above are used. This time difference $\Delta t$ (reference numeral 205) is a first signal variation parameter between a portion of the first electrical signal 201 and the corresponding portion of the second electrical signal 202.

Another signal variation parameter is the shape variation. More particularly, with respect to the portion of the first electrical signal 201, there is a variation of the shape of the corresponding portion or the second electrical signal 202, as is shown in Figs. 7(b) and 7(c). This shape variation allows determining an amount of an impedance mismatch or impedance variation in accordance with equation (1) above. Thus, a critical conducting section 203 may be evaluated with respect to its location and its nature or impact on a power transfer on the power cable 200. If signal shape variations have been stored in the memory unit of the evaluation unit 103 and if tests have been performed as reference measurements using power cables with different impedance variations, a maximum load rating of the critical conducting section 203 of a power cable 200 actually tested is obtained.

Thus, the control signal 206 may be output in order to control the power supply network 400 such that the power transferred on the critical conducting section 203 does not exceed this maximum load rating. The maximum load rating is obtained from measurements which may be performed before power cable 200 is tested. Here appropriate impedance mismatches which are arbitrarily introduced into an reference power cable 200 may be used. Thus, a power cable 200 which is actually tested may be compared to a power cable 200 which has been measured previously.

The above comparison and calibration of the cable for obtaining the maximum load rating has been described with reference to the real-time shape of the signals. Again, an evaluation e.g. in frequency-domain can be used instead. To this purpose, the Fourier transformed or partially Fourier transformed signals can be evaluated and / or compared. Here, the signal variation parameter may include e.g. signal strength ratios between the first signal and the second signal for different frequencies, and / or phase shifts between the first signal and the second signal for different frequencies.

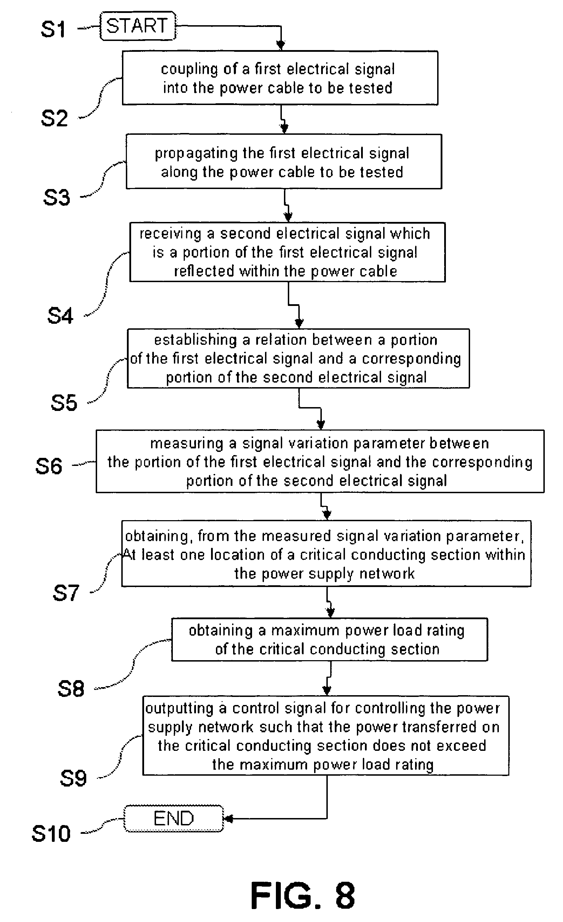

Fig. 8 is a flowchart illustrating a method for testing a power cable arranged within a power supply network (where it is understood that the method could be used more generally for testing a power distribution system). The procedure starts at a step S1 and then advances to a step S2 where a first electrical signal is coupled into the power cable 200 to be tested. In a following step S3, the first electrical signal 201 is propagated along the power cable 200 to be tested. If the power cable 200 to be tested includes a critical conducting section 203 where an impedance mismatch is present such that a signal reflection occurs, a second electrical signal 202 which is a portion of the first electrical signal 201 may be received at a step S4.

The procedure advances to a step S5 where a relation between a portion of the first electrical signal 201 and a corresponding portion of the second electrical signal 202 is determined by means of the evaluation unit 103 described herein above with respect to Fig. 6. At a step S6 which follows, a signal variation parameter between the portion of the first electrical signal 201 and the corresponding portion of the second electrical signal 202 is measured. Then, the procedure advances to a step S7 where a location of a critical conducting section within the power supply network is obtained from the measured signal variation parameter. In a following step S8, a maximum load rating of the critical conducting section is obtained by analysing the reflected signal, i.e. the second electrical signal 202, e.g. with respect to its shape variation compared to the first electrical signal 201.

Then, the procedure advances to a step S9 where a control signal is output, the control signal being adapted for controlling the power supply network 400 such that the power transferred on the critical conducting section 203 does not exceed the maximum load rating. Then, the procedure is ended at a step S10.

It is noted here that the application of the power cable analyser device 100 and the method for testing a power cable 200 has been described with respect to power supply networks. It is possible, however, to use the analyser device for testing electrical cables in other applications such as airplanes, power plants, cars, etc.

The invention has been described on the basis of embodiments which are shown in the appended drawings and from which further advantages and modifications emerge. However, the disclosure is not restricted to the embodiments described in concrete terms, but rather can be modified and varied in a suitable manner. It lies within the scope to combine individual features and combinations of features of one embodiment with features and combinations of features of another embodiment in a suitable manner in order to arrive at further embodiments.

It will be apparent to those skilled in the art, based upon the teachings herein, that changes and modifications may be made without departing from the disclosure and its broader aspects. That is, all examples set forth herein above are intended to be exemplary and non-limiting.

## REFERENCE NUMERALS

| No. | Part/step |
| --- | --- |
| 100 | power cable analyser device |
| 101 | transmitter unit |
| 102 | receiver unit |
| 103 | evaluation unit |
| 104 | output unit |
| 105 | control unit |
| 200 | power cable / |
| 201 | first electrical signal |
| 202 | second electrical signal |
| 203 | critical conducting section |
| 204 | cable junction |

(continued)

| No. | Part/step |
|-----|-----------|
| 205 | time delay |
| 206 | control signal |
| 207 | forward propagation direction |
| 208 | backward propagation direction |
| 209 | control line |
| 210 | power distribution system to be tested |
| 300 | coupling unit |
| 400 | power supply network |
| 401 | substation |
| 402 | substation |
| 403 | substation |
| 404 | substation |

**Claims**

1. A method for testing a power distribution system (210) of a power supply network (400), the method comprising:

   coupling of a first electrical signal (201) into the power distribution system (210) to be tested;
   propagating the first electrical signal (201) within the power distribution system (210) to be tested;
   receiving a second electrical signal (202) which is a portion of the first electrical signal (201) reflected within the power distribution system (210);
   measuring a signal variation parameter between the first electrical signal (201) and the second electrical signal (202);
   obtaining, from the measured signal variation parameter, at least one location of a critical conducting section (203) within the power distribution system (210);
   **characterized in that** the method further comprises
   obtaining, from the measured signal variation parameter, a maximum load rating of the critical conducting section (203); and
   outputting a control signal for controlling the power supply network (400) such that the power transferred on the critical conducting section (203) does not exceed the maximum load rating.

2. The method in accordance with claim 1, wherein the signal variation parameter comprises a variation in at least one of a time domain, a spread spectrum time domain, a frequency domain, or a combination of the above such as a mixed signal suitable for a mixed-signal reflectometer.

3. The method in accordance with claim 1 or 2, wherein the first electrical signal (201) is coupled, preferably capacitively or galvanically coupled, into a power cable (200) of the power distribution system (210) to be tested, and wherein preferably the method further comprises extracting power from the power cable and using the extracted power for the testing of the power distribution system.

4. The method in accordance with any one of the preceding claims, wherein the measured signal variation parameter is compared to a stored reference signal variation parameter, wherein the maximum load rating is determined from the comparison.

5. The method in accordance with any one of the preceding claims, wherein at least two signal variation parameters are measured for at least two critical conducting sections of the power distribution system (210), such as two power cables (200) and / or power cable (200) sections of the power distribution system (210), wherein the measured at least two signal variation parameters are compared to each other, and wherein the maximum load rating is determined from the at least two signal variation parameters, preferably by comparing at least two load ratings obtained when the signal variation parameters for the at least two critical conducting sections are measured.

6. The method in accordance with any one of the preceding claims, wherein the signal variation parameter comprises a parameter indicating an impedance variation, preferably a spatial impedance variation between an impedance of the critical conducting section (203) and an impedance of a conducting section adjacent to the critical conducting section (203), and / or a parameter indicating a temporal variation.

7.  The method in accordance with any one of the preceding claims, wherein an operating condition of the power distribution system (210) is obtained by analysing a shape variation, with respect to the first electrical signal (201), of the second electrical signal (202), and wherein the maximum load rating is determined from the operating condition.

8.  The method in accordance with claim 7, wherein the operating condition of the power distribution system (210) comprises at least one of the following:

    (i) an operating condition of a power cable interrupter of the power distribution system (210);
    (ii) an electrical property of a power cable (200) of the power distribution system (210), preferably at least one of a ground contact, a blown fuse, an open circuit, a short circuit, a partially open circuit, a partially short circuit, an insulation state, a partial discharge, and an arc fault;
    (iii) a property of a cable environment or cable isolation of a power cable (200) of the power distribution system (210), preferably at least one of an ambient humidity, a water intrusion into the interior of the power cable (200) isolation, temperature variations, and/or the presence of sand, wet grass, gravel, and/or stones in the vicinity of the cable.

9.  The method in accordance with any one of the preceding claims, further comprising
    predicting whether there is a significant risk of a future fault at the critical conducting section (203), the prediction being based on the measured signal variation parameter and more preferably being based on a time-dependent behaviour of the measured signal variation parameter.

10. The method in accordance with any one of the preceding claims, wherein the first electrical signal (201) is propagated while a predetermined electrical load is simultaneously applied at the power distribution system (210).

11. An analyser device adapted for testing a power distribution system (210) of a power supply network (400), the analyser device comprising:

    a transmitter unit adapted for transmitting a first electrical signal (201);
    a coupling unit adapted for coupling the first electrical signal (201) into the power distribution system (210) to be tested, for propagating the first electrical signal (201) within the power distribution system (210) to be tested;
    a receiver unit adapted for receiving a second electrical signal (202) which results from a portion of the first electrical signal (201) being reflected within the power distribution system (210);
    an evaluation unit adapted for measuring a signal variation parameter between the first electrical signal (201) and the second electrical signal (202) and for obtaining, from the measured signal variation parameter, a location of a critical conducting section (203) within the power distribution system (210) and a maximum load rating of the critical conducting section (203); and
    an output unit adapted for outputting a control signal for controlling the power supply network (400) such that the power transferred on the critical conducting section (203) does not exceed a maximum load rating.

12. The analyser device in accordance with claim 11, wherein the transmitter unit and the receiver unit are provided as an integral transceiver unit.

13. The analyser device in accordance with claim 11 or 12, further comprising a correlator unit adapted for correlating the first electrical signal (201) and the second electrical signal (202).

14. The analyser device in accordance with any one of the claims 11 to 13, wherein the analyser device is integrated in a bushing of a power cable (200) of the power distribution system (210) to be tested.

15. The analyser device in accordance with any one of the claims 11 to 14, wherein
    the coupling unit is adapted for coupling the first electrical signal (201) into a power cable (200) of the power distribution system (210) to be tested, and wherein a power supply for the analyser device is provided via the power cable.

**Patentansprüche**

1. Verfahren zum Testen eines Energieverteilungssystems (210) eines Energieversorgungsnetzes (400), wobei das Verfahren umfasst:

   Koppeln eines ersten elektrischen Signals (201) in das zu testende Energieverteilungssystem (210);
   Ausbreiten des ersten elektrischen Signals (201) in dem zu testenden Energieverteilungssystem (210);
   Empfangen eines zweiten elektrischen Signals (202), das ein Teil des ersten elektrischen Signals (201) ist, der innerhalb des Energieverteilungssystems (210) reflektiert wird;
   Messen eines Signalvariationsparameters zwischen dem ersten elektrischen Signal (201) und dem zweiten elektrischen Signal (202);
   Erhalten wenigstens eines Ortes eines kritischen Leitungsabschnitts (203) innerhalb des Energieverteilungssystems (210) aus dem gemessenen Signalvariationsparameter;
   **dadurch gekennzeichnet, dass** das Verfahren ferner umfasst:

   Erhalten eines maximalen Last-Nennwerts des kritischen Leitungsabschnitts (203) aus dem gemessenen Signalvariationsparameter; und
   Ausgeben eines Steuersignals zum Steuern des Energieversorgungsnetzes (400), so dass die in dem kritischen Leitungsabschnitt (203) übertragene Energie den maximalen Last-Nennwert nicht übersteigt.

2. Verfahren nach Anspruch 1, wobei der Signalvariationsparameter eine Variation in einem Zeitbereich und/oder einem Spreizspektrum-Zeitbereich und/oder einem Frequenzbereich oder einer Kombination der obigen, wie z. B. als ein gemischtes Signal, das für ein Mischsignal-Reflektometer geeignet ist, umfasst.

3. Verfahren nach Anspruch 1 oder 2, wobei das erste elektrische Signal (201) in ein Starkstromkabel (200) des zu testenden Energieverteilungssystems (210), vorzugsweise kapazitiv oder galvanisch, gekoppelt wird, und wobei das Verfahren ferner vorzugsweise das Extrahieren der Energie aus dem Starkstromkabel und das Verwenden der extrahierten Energie für das Testen des Energieverteilungssystems umfasst.

4. Verfahren nach einem der vorhergehenden Ansprüche, wobei der gemessene Signalvariationsparameter mit einem gespeicherten Referenz-Signalvariationsparameter verglichen wird, wobei der maximale Last-Nennwert aus dem Vergleich bestimmt wird.

5. Verfahren nach einem der vorhergehenden Ansprüche, wobei wenigstens zwei Signalvariationsparameter für wenigstens zwei kritische Leitungsabschnitte des Energieverteilungssystems (210), wie z. B. zwei Starkstromkabel (200) und/oder Abschnitte des Starkstromkabels (200) des Energieverteilungssystems (210), gemessen werden, wobei die gemessenen wenigstens zwei Signalvariationsparameter miteinander verglichen werden und wobei der maximale Last-Nennwert aus den wenigstens zwei Signalvariationsparametern bestimmt wird, vorzugsweise durch das Vergleichen von wenigstens zwei Last-Nennwerten, die erhalten werden, wenn die Signalvariationsparameter für die wenigstens zwei kritischen Leitungsabschnitte gemessen werden.

6. Verfahren nach einem der vorhergehenden Ansprüche, wobei der Signalvariationsparameter einen Parameter, der eine Impedanzvariation, vorzugsweise eine räumliche Impedanzvariation zwischen einer Impedanz des kritischen Leitungsabschnitts (203) und einer Impedanz eines dem kritischen Leitungsabschnitt (203) benachbarten Leitungsabschnitts, angibt, und/oder einen Parameter, der eine zeitliche Variation angibt, umfasst.

7. Verfahren nach einem der vorhergehenden Ansprüche, wobei eine Betriebsbedingung des Energieverteilungssystems (210) durch das Analysieren einer Formvariation des zweiten elektrischen Signals (202) bezüglich des ersten elektrischen Signals (201) erhalten wird und wobei der maximale Last-Nennwert aus der Betriebsbedingung bestimmt wird.

8. Verfahren nach Anspruch 7, wobei die Betriebsbedingung des Energieverteilungssystems (210) wenigstens eine der Folgenden umfasst:

   (i) eine Betriebsbedingung eines Starkstromkabel-Unterbrechers des Energieverteilungssystems (210);
   (ii) eine elektrische Eigenschaft eines Starkstromkabels (200) des Energieverteilungssystems (210), vorzugsweise einen Erdkontakt und/oder eine durchgebrannte Sicherung und/oder einen offenen Stromkreis und/oder einen Kurzschluss und/oder einen teilweise offenen Stromkreis und/oder einen teilweisen Kurzschluss und/oder einen Isolationszustand und/oder eine teilweise Entladung und/oder einen Kurzschlusslichtbogen;
(iii) eine Eigenschaft einer Kabelumgebung oder einer Kabelisolation des Starkstromkabels (200) des Energieverteilungssystems (210), vorzugsweise Umgebungsfeuchtigkeit und/oder ein Eindringen von Wasser in das Innere der Isolation des Starkstromkabels (200) und/oder Temperaturvariationen und/oder das Vorhandensein von Sand, nassem Gras, Kies und/oder Steinen in der Umgebung des Kabels.

9. Verfahren nach einem der vorhergehenden Ansprüche, das ferner umfasst:

Vorhersagen, ob es ein signifikantes Risiko einer künftigen Störung im kritischen Leitungsabschnitt (203) gibt, wobei die Vorhersage auf dem gemessenen Signalvariationsparameter basiert und bevorzugter auf dem zeitabhängigen Verhalten des gemessenen Signalvariationsparameters basiert.

10. Verfahren nach einem der vorhergehenden Ansprüche, wobei das erste elektrische Signal (201) ausgebreitet wird, während gleichzeitig an das Energieverteilungssystem (210) eine vorgegebene elektrische Last angelegt ist.

11. Analysevorrichtung, die für das Testen eines Energieverteilungssystems (210) eines Energieversorgungsnetzes (400) ausgelegt ist, wobei die Analysevorrichtung umfasst:

eine Sendereinheit, die für das Senden eines ersten elektrischen Signals (201) ausgelegt ist;
eine Kopplungseinheit, die für das Koppeln des ersten elektrischen Signals (201) in das zu testende Energieverteilungssystem (210) ausgelegt ist, um das erste elektrische Signal (201) innerhalb des zu testenden Energieverteilungssystems (210) auszubreiten;
eine Empfängereinheit, die für das Empfangen eines zweiten elektrischen Signals (202), das sich aus einem Teil des ersten elektrischen Signals (201), der innerhalb des Energieverteilungssystems (210) reflektiert wird, ergibt, ausgelegt ist;
eine Auswertungseinheit, die für das Messen eines Signalvariationsparameters zwischen dem ersten elektrischen Signal (201) und dem zweiten elektrischen Signal (202) und zum Erhalten eines Ortes eines kritischen Leitungsabschnitts (203) innerhalb des Energieverteilungssystems (210) und eines maximalen Last-Nennwerts des kritischen Leitungsabschnitts (203) aus dem gemessenen Signalvariationsparameter ausgelegt ist; und
eine Ausgabeeinheit, die zum Ausgeben eines Steuersignals zum Steuern des Energieversorgungsnetzes (400) ausgelegt ist, so dass die in dem kritischen Leitungsabschnitt (203) übertragene Energie den maximalen Last-Nennwert nicht übersteigt.

12. Analysevorrichtung nach Anspruch 11, wobei die Sendereinheit und die Empfängereinheit als eine einteilige Sender/Empfänger-Einheit vorgesehen sind.

13. Analysevorrichtung nach Anspruch 11 oder 12, die ferner eine Korrelatoreinheit umfasst, die für das Korrelieren des ersten elektrischen Signals (201) und des zweiten elektrischen Signals (202) ausgelegt ist.

14. Analysevorrichtung nach einem der Ansprüche 11 bis 13, wobei die Analysevorrichtung in einer Buchse eines Starkstromkabels (200) des zu testenden Energieverteilungssystems (210) integriert ist.

15. Analysevorrichtung nach einem der Ansprüche 11 bis 14, wobei
die Kopplungseinheit für das Koppeln des ersten elektrischen Signals (201) in ein Starkstromkabel (200) des zu testenden Energieverteilungssystems (210) ausgelegt ist, und wobei eine Energieversorgung für die Analysevorrichtung über das Starkstromkabel vorgesehen ist.

**Revendications**

1. Procédé pour tester un système de distribution électrique (210) d'un réseau d'alimentation électrique (400), lequel procédé consiste à :

- coupler un premier signal électrique (201) dans le système de distribution électrique (210) à tester ;
- propager le premier signal électrique (201) dans le système de distribution électrique (210) à tester ;
- recevoir un second signal électrique (202) consistant en une partie du premier signal électrique (201) réfléchie dans le système de distribution électrique (210) ;
- mesurer un paramètre de variation de signal entre le premier signal électrique (201) et le second signal électrique (202) ;
- obtenir, à partir du paramètre de variation de signal mesuré, au moins un emplacement d'une section conductrice critique (203) dans le système de distribution électrique (210) ;

**caractérisé en ce que** ledit procédé consiste en outre à :

- obtenir, à partir du paramètre de variation de signal mesuré, une valeur de charge maximale de la section conductrice critique (203) ; et
- émettre un signal de commande afin de commander le réseau d'alimentation électrique (400) de sorte que la puissance transférée vers la section conductrice critique (203) ne dépasse pas la valeur de charge maximale.

2. Procédé selon la revendication 1, dans lequel le paramètre de variation de signal comprend une variation dans au moins l'un des domaines comprenant un domaine temporel, un domaine temporel à spectre étalé, un domaine de fréquence ou une combinaison de ces derniers, comme un signal mélangé convenant à un réflectomètre à signal mélangé.

3. Procédé selon la revendication 1 ou 2, dans lequel le premier signal électrique (201) est couplé, de préférence de manière capacitive ou galvanique, dans un câble électrique (200) du système de distribution électrique (210) à tester, et dans lequel le procédé consiste en outre et de préférence à extraire l'électricité du câble électrique et à utiliser l'électricité extraite afin de tester le système de distribution électrique.

4. Procédé selon l'une quelconque des revendications précédentes, dans lequel le paramètre de variation de signal mesuré est comparé à un paramètre de variation de signal de référence enregistré, la valeur de charge maximale étant déterminée à partir de cette comparaison.

5. Procédé selon l'une quelconque des revendications précédentes, dans lequel au moins deux paramètres de variation de signal sont mesurés pour au moins deux sections conductrices critiques du système de distribution électrique (210), comme deux câbles électriques (200) et/ou sections de câble électrique (200) du système de distribution électrique (210), dans lequel lesdits au moins deux paramètres de variation de signal mesurés sont comparés l'un à l'autre, et dans lequel la valeur de charge maximale est déterminée à partir desdits au moins deux paramètres de variation de signal, de préférence en comparant au moins deux valeurs de charge obtenues lorsque les paramètres de variation de signal pour lesdites au moins deux sections conductrices critiques sont mesurés.

6. Procédé selon l'une quelconque des revendications précédentes, dans lequel le paramètre de variation de signal comprend un paramètre indiquant une variation d'impédance, de préférence une variation d'impédance spatiale entre une impédance de la section conductrice critique (203) et une impédance d'une section conductrice adjacente à la section conductrice critique (203) et/ou un paramètre indiquant une variation temporelle.

7. Procédé selon l'une quelconque des revendications précédentes, dans lequel une condition de fonctionnement du système de distribution électrique (210) est obtenue en analysant une variation de forme du second signal électrique (202) par rapport au premier signal électrique (201), et dans lequel la valeur de charge maximale est déterminée à partir de la condition de fonctionnement.

8. Procédé selon la revendication 7, dans lequel la condition de fonctionnement du système de distribution électrique (210) comprend au moins un des éléments suivants :

(i) une condition de fonctionnement d'un interrupteur de câble électrique du système de distribution électrique (210) ;
(ii) une propriété électrique d'un câble électrique (200) du système de distribution électrique (210), de préférence au moins une des situations comprenant un contact à la terre, un fusible grillé, un circuit ouvert, un court-circuit, un circuit partiellement ouvert, un court-circuit partiel, un état d'isolation, une décharge partielle et une défaillance par arc ;
(iii) une propriété d'environnement de câble ou d'isolation de câble d'un câble électrique (200) du système de distribution électrique (210), de préférence au moins une des situations comprenant une humidité ambiante, une intrusion d'eau à l'intérieur de l'isolation du câble électrique (200), des variations de température, et/ou la présence de sable, d'herbe mouillée, de gravier et/ou de pierres à proximité du câble.

9. Procédé selon l'une quelconque des revendications précédentes, consistant en outre à prédire s'il existe un risque important de défaillance future au niveau de la section conductrice critique (203), la prédiction se fondant sur le paramètre de variation de signal mesuré et, de préférence, sur un comportement dépendant du temps du paramètre de variation de signal mesuré.

10. Procédé selon l'une quelconque des revendications précédentes, dans lequel le premier signal électrique (201) se propage pendant qu'une charge électrique prédéterminée est simultanément appliquée au système de distribution électrique (210).

11. Dispositif d'analyse conçu pour tester un système de distribution électrique (210) d'un réseau d'alimentation électrique (400), lequel dispositif d'analyse comprend :

- une unité émettrice conçue pour émettre un premier signal électrique (201) ;
- une unité de couplage conçue pour coupler le premier signal électrique (210) dans le système de distribution électrique (210) à tester afin de propager le premier signal électrique (201) dans le système de distribution électrique (210) à tester ;
- une unité réceptrice conçue pour recevoir un second signal électrique (202) résultant d'une partie du premier signal électrique (201) réfléchie dans le système de distribution électrique (210) ;
- une unité d'évaluation conçue pour mesurer un paramètre de variation de signal entre le premier signal électrique (201) et le second signal électrique (202), et pour obtenir, à partir du paramètre de variation de signal mesuré, un emplacement d'une section conductrice critique (203) dans le système de distribution électrique (210) et une valeur de charge maximale de la section conductrice critique (203) ; et
- une unité de sortie conçue pour émettre un signal de commande afin de commander le réseau d'alimentation électrique (400) de sorte que la puissance transférée vers la section conductrice critique (203) ne dépasse pas une valeur de charge maximale.

12. Dispositif d'analyse selon la revendication 11, dans lequel l'unité émettrice et l'unité réceptrice se présentent sous forme d'une unité émettrice-réceptrice intégrale.

13. Dispositif d'analyse selon la revendication 11 ou 12, comprenant en outre une unité de corrélation conçue pour effectuer une corrélation du premier signal électrique (201) et du second signal électrique (202).

14. Dispositif d'analyse selon l'une quelconque des revendications 11 à 13, lequel est intégré dans une traversée d'un câble électrique (200) du système de distribution électrique (210) à tester.

15. Dispositif d'analyse selon l'une quelconque des revendications 11 à 14, dans lequel l'unité de couplage est conçue pour coupler le premier signal électrique (201) dans un câble électrique (200) du système de distribution électrique (210) à tester, et dans lequel une alimentation électrique du dispositif d'analyse est assurée par le câble électrique.

400

402

404

210

300

300

100

100

203

200

203

200

203

200

300

300

401

100

204

100

403

FIG. 1

FIG. 2

FIG. 3

FIG. 4

FIG. 5

FIG. 6

FIG. 7

S1 — START

S2 — coupling of a first electrical signal
into the power cable to be tested

S3 — propagating the first electrical signal
along the power cable to be tested

S4 — receiving a second electrical signal which
is a portion of the first electrical signal
reflected within the power cable

S5 — establishing a relation between a portion
of the first electrical signal and a corresponding
portion of the second electrical signal

S6 — measuring a signal variation parameter between
the portion of the first electrical signal and the corresponding
portion of the second electrical signal

S7 — obtaining, from the measured signal variation parameter,
At least one location of a critical conducting section within
the power supply network

S8 — obtaining a maximum power load rating
of the critical conducting section

S9 — outputting a control signal for controlling the power
supply network such that the power transferred on
the critical conducting section does not exceed
the maximum power load rating

S10 — END

# FIG. 8

EP 2 221 626 B1

**REFERENCES CITED IN THE DESCRIPTION**

**Patent documents cited in the description**

- EP 1744429 A